(19) **Europäisches Patentamt European Patent Office Office européen des brevets**

(11) **EP 2 707 935 B1**

(12) **FASCICULE DE BREVET EUROPEEN**

(45) Date de publication et mention de la délivrance du brevet:
**08.06.2016 Bulletin 2016/23**

(51) Int Cl.:
***H01M 10/44*** *(2006.01)*     ***H01M 10/48*** *(2006.01)*
***H02J 7/00*** *(2006.01)*     ***B60L 11/18*** *(2006.01)*
***G01R 31/36*** *(2006.01)*     ***H01M 10/42*** *(2006.01)*

(21) Numéro de dépôt: **12722100.0**

(22) Date de dépôt: **07.05.2012**

(86) Numéro de dépôt international:
**PCT/EP2012/058400**

(87) Numéro de publication internationale:
**WO 2012/152770 (15.11.2012 Gazette 2012/46)**

(54) **PROCEDE DE GESTION ET DIAGNOSTIC D'UNE BATTERIE**

VERFAHREN ZUR BATTERIEVERWALTUNG UND DIAGNOSE

METHOD FOR BATTERY MANAGEMENT AND DIAGNOSIS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.05.2011 FR 1153949**

(43) Date de publication de la demande:
**19.03.2014 Bulletin 2014/12**

(73) Titulaire: **Commissariat à l'Énergie Atomique et aux Énergies Alternatives 75015 Paris (FR)**

(72) Inventeurs:
- **BRUN-BUISSON, David F-38470 Vatilieu (FR)**
- **ZARA, Henri F-69380 Charnay (FR)**

(74) Mandataire: **Novaimo Bâtiment Europa 2 310 avenue Marie Curie Archamps Technopole 74166 Saint-Julien-en-Genevois Cedex (FR)**

(56) Documents cités:
**WO-A1-2006/112512     FR-A1- 2 750 507**

**Description**

L'invention concerne un procédé de gestion d'une batterie, comprenant notamment la réalisation du diagnostic de ses différents sous-ensembles. Elle concerne aussi une batterie en tant que telle comprenant un agencement permettant de mettre en oeuvre ce procédé de gestion. Enfin, elle concerne aussi un système de gestion de batterie mettant en oeuvre ce procédé de gestion de batterie.

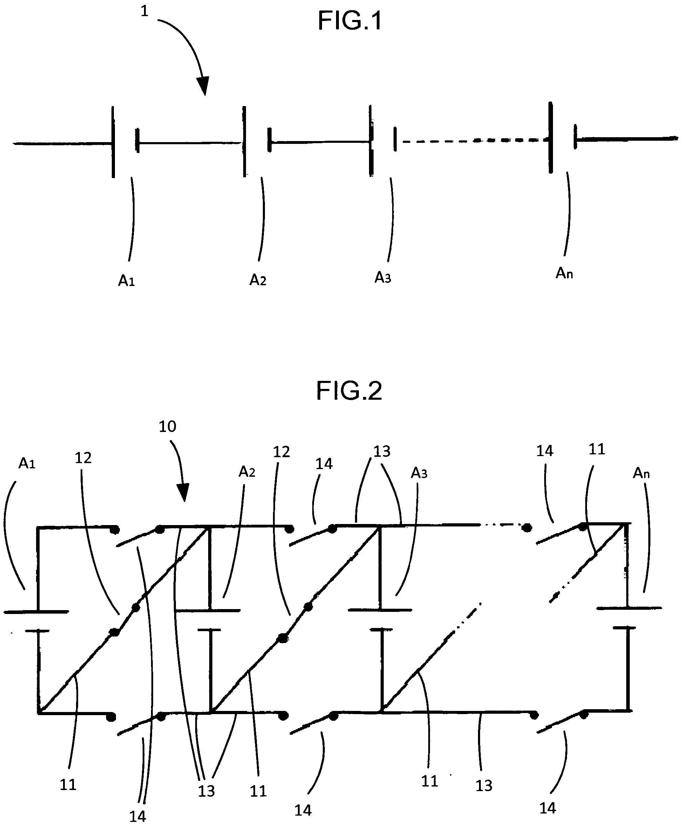

Il existe des batteries d'accumulateurs composées d'un assemblage de plusieurs accumulateurs, disposés en série, afin de fournir une tension de sortie suffisante dans certaines applications exigeantes, comme pour l'alimentation d'un moteur d'entraînement d'un véhicule automobile. La figure 1 illustre ainsi schématiquement une telle architecture de batterie 1, qui comprend n accumulateurs $A_i$ disposés en série.

Le document US2008072859 décrit une batterie dont l'architecture est du type précédent, mais qui permet de plus de disposer les différents accumulateurs en série ou en parallèle, à l'aide d'interrupteurs intercalés entre les accumulateurs, pilotés par un circuit électronique dédié. Cette solution permet la mise en oeuvre d'un équilibrage entre les accumulateurs en les disposant en parallèle, ce qui induit l'équilibrage de charges automatique entre les accumulateurs. Cet équilibrage des différents accumulateurs est réalisé à la fin d'une période de charge : il permet de positionner la batterie dans une configuration idéale avant sa prochaine utilisation.

La gestion des batteries de l'état de la technique fait appel à un indicateur représentatif du vieillissement d'une batterie, souvent appelé par sa dénomination anglo-saxonne de « State Of Health » pour état de santé, ou plus simplement SOH. Cet indicateur est couramment utilisé dans le diagnostic d'une batterie. L'évaluation de cet indicateur est importante pour une bonne maîtrise du fonctionnement de la batterie, ainsi que pour gérer au mieux sa fin de vie. L'estimation du SOH est réalisée lors d'une opération de diagnostic spécifique durant laquelle la batterie n'est pas utilisée. De plus, les solutions préconisées pour la réalisation de ce diagnostic ne sont toutefois pas optimales.

Ainsi, un objet général de l'invention est de proposer une solution de gestion d'une batterie qui permet d'améliorer la réalisation du diagnostic de l'état de la batterie, et plus particulièrement le calcul de son état de santé SOH.

A cet effet, l'invention repose sur un procédé de gestion d'une batterie comprenant plusieurs accumulateurs pouvant être liés en série ou en parallèle, comprenant une phase de charge ou de décharge durant laquelle les accumulateurs sont disposés en série, comprenant ensuite une phase d'équilibrage comprenant la mise en parallèle des accumulateurs, caractérisé en ce que durant laquelle une grandeur électrique $G_{min}$ représentant l'équilibrage de l'accumulateur ayant atteint la tension maximale lors de la phase de charge ou minimale lors de la phase de décharge est mesurée ou estimée, et durant laquelle une grandeur électrique $G_i$ représentant l'équilibrage d'un autre accumulateur i de la batterie est aussi mesurée ou estimée, et en ce que l'état de santé $SOH_i$ de cet autre accumulateur i est calculé à partir des deux grandeurs électriques $G_{min}$ et $G_i$ et à partir de la connaissance de la performance de l'accumulateur i en début de vie.

Le procédé de gestion d'une batterie peut comprendre une étape préliminaire de décharge totale ou de charge totale et d'équilibrage de tous les accumulateurs.

L'état de santé $SOH_i$ de l'accumulateur i peut être calculé comme le rapport entre sa capacité maximale en fin de phase d'équilibrage de la batterie et sa capacité maximale en début de vie et les deux grandeurs $G_{min}$ et $G_i$ peuvent être des capacités en A.h.

Le procédé de gestion d'une batterie peut comprendre les étapes suivantes :

- mesure ou estimation de la capacité chargée X pendant la phase de charge ou de la capacité déchargée pendant la phase de décharge ;
- mesure ou estimation de la charge d'équilibrage $X_{Emin}$ de l'accumulateur ayant atteint la tension maximale à la fin de la phase de charge ou la tension minimale à la fin de la phase de décharge ;
- mesure ou estimation de la charge d'équilibrage $X_{Ei}$ de l'accumulateur i ;
- calcul de l'état de santé $SOH_i$ de l'accumulateur i par la formule suivante :

$$SOH_i = \frac{(X+X_{Ei}) \times 100}{C_i\,(X+X_{Emin})/X}$$

Où $C_i$ représente la capacité maximale en début de vie de l'accumulateur i.

Le procédé de gestion d'une batterie peut comprendre les étapes suivantes :

- mesure du courant I de charge ou de décharge traversant tous les accumulateurs disposés en série et calcul de la capacité chargée X pendant la phase de charge ou de la capacité déchargée pendant la phase de décharge par la formule $X = \int I\,dt$ sur la durée de la phase de charge ou de décharge ;

- mesure du courant $I_{Emin}$ d'équilibrage au niveau de l'accumulateur ayant atteint la tension maximale en fin de phase de charge ou la tension minimale en fin de phase de décharge et calcul de la charge d'équilibrage $X_{Emin}$ pendant la phase d'équilibrage par la formule $X_{Emin} = \int I_{Emin}\,dt$ sur la durée de la phase d'équilibrage ;
- mesure du courant $I_{Ei}$ d'équilibrage au niveau de l'accumulateur i et calcul de la charge d'équilibrage $X_{Ei}$ pendant la phase d'équilibrage par la formule $X_{Ei} =$

∫ $I_{Ei}$ dt sur la durée de la phase d'équilibrage.

L'état de santé $SOH_i$ de l'accumulateur i peut être calculé comme le rapport entre l'énergie maximale stockée en fin de phase d'équilibrage de la batterie et son énergie maximale stockée en début de vie et les deux grandeurs $G_{min}$ et $G_i$ peuvent être des énergies.

Le procédé de gestion d'une batterie peut comprendre une étape de calcul de l'état de santé SOH de tous les accumulateurs de la batterie pendant les phases de recharge et d'équilibrage de la batterie ou de décharge et d'équilibrage de la batterie.

L'invention porte aussi sur une batterie comprenant plusieurs accumulateurs pouvant être connectés en série ou en parallèle, caractérisée en ce qu'elle comprend un calculateur qui met en oeuvre le procédé de gestion tel que décrit précédemment.

La batterie peut comprendre des interrupteurs entre différents accumulateurs pour les disposer en série ou en parallèle, au moins un capteur de mesure, un circuit de commande des interrupteurs et un calculateur qui reçoit les mesures et effectue le calcul de l'état de santé d'au moins un accumulateur.

L'invention porte aussi sur un système de gestion d'une batterie, caractérisé en ce qu'il comprend au moins un calculateur qui met en oeuvre le procédé de gestion d'une batterie tel que décrit précédemment.

Ces objets, caractéristiques et avantages de la présente invention seront exposés en détail dans la description suivante d'un mode de réalisation particulier fait à titre non-limitatif en relation avec les figures jointes parmi lesquelles :

La figure 1 représente schématiquement l'architecture d'une batterie selon un état de la technique.

La figure 2 représente schématiquement l'architecture d'une batterie selon un mode de réalisation de l'invention dans une configuration série.

La figure 3 représente schématiquement l'architecture d'une batterie selon le mode de réalisation de l'invention dans une configuration parallèle.

La figure 4 représente plus précisément l'architecture d'une batterie selon le mode de réalisation de l'invention.

Le procédé de l'invention dont un mode de réalisation va être décrit ci-dessous s'applique tant lors d'une charge d'une batterie que lors d'une décharge. Le mode de réalisation qui va suivre se rapporte à une charge de batterie mais il est aisé de le transposer à une décharge d'une batterie. La figure 2 représente une batterie 10 selon un mode d'exécution de l'invention, qui comprend comme précédemment l'association de n accumulateurs $A_i$. La liaison entre ces accumulateurs comprend une première branche 11 disposée entre leurs bornes de signe opposé, sur laquelle est disposé un premier interrupteur 12, que nous appellerons « interrupteurs série ». Elle comprend ensuite deux autres branches 13 reliant respectivement leurs deux bornes de signe identique et comprenant un interrupteur 14 chacune, que nous appellerons « interrupteur parallèle ».

Sur la figure 2, les interrupteurs série 12 sont fermés alors que les interrupteurs 14 sont ouverts, ce qui permet de disposer les accumulateurs en série, selon une configuration série, équivalente au schéma de la figure 1.

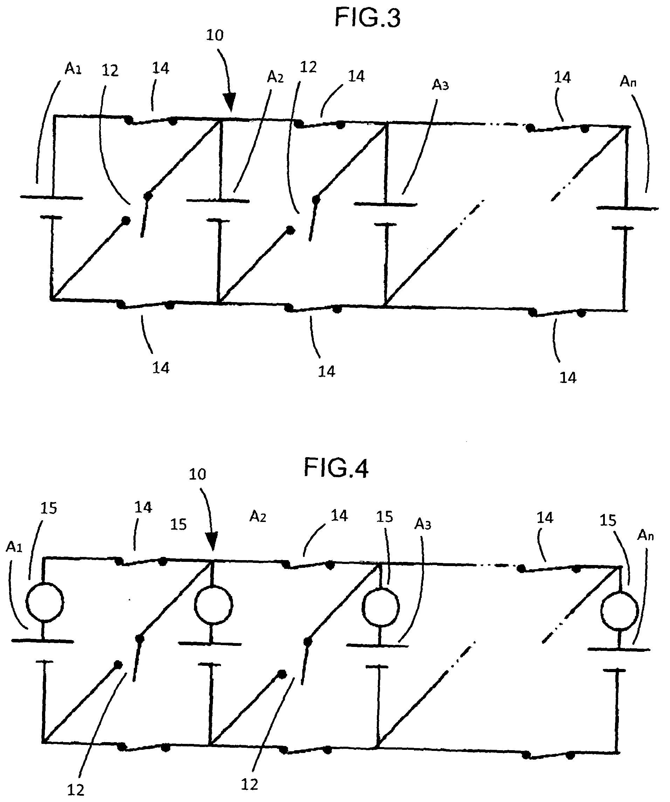

Au contraire, sur la figure 3, les interrupteurs série 12 sont ouverts alors que les interrupteurs 14 sont fermés, ce qui permet de disposer les accumulateurs en parallèle, selon une configuration parallèle.

Une telle architecture de batterie permet la mise en oeuvre d'un procédé de gestion de la batterie qui comprend son diagnostic et le calcul de l'état de santé SOH de tous ses accumulateurs, qui va maintenant être décrit.

Ce procédé est mis en oeuvre lors des phases de charge ou décharge et d'équilibrage de la batterie et présente l'avantage de ne pas nécessiter une phase distincte, qui immobiliserait la batterie pendant une durée supplémentaire.

En effet, selon une première étape, le procédé comprend une étape de calcul de la capacité chargée dans chaque accumulateur durant la phase de charge de la batterie, durant laquelle elle se trouve en configuration série, c'est-à-dire que tous ses accumulateurs reçoivent le même courant de charge constant I. La charge X reçue par tous les accumulateurs est donc obtenue par la formule suivante, intégrée sur la durée de cette phase de charge : $X = \int I \, dt$.

Cette phase de charge se termine selon les critères de fin de charge conventionnels, c'est-à-dire lorsqu'un accumulateur a atteint la tension maximale définie par sa technologie. En fin de charge, les différents accumulateurs sont en général dans des conditions différentes, la tension finale à leur borne étant différente, du fait de leur état variable, comme leur vieillissement différent. C'est pourquoi cette phase de charge est suivie d'une phase d'équilibrage. Pour cela, la batterie est mise en configuration parallèle. Les accumulateurs tendent alors naturellement vers une tension identique, ce qui s'accompagne d'un transfert de charges entre eux.

Le procédé comprend alors une seconde étape de calcul de la capacité chargée lors de cette phase d'équilibrage. Pour cela, cette capacité chargée d'équilibrage $X_{Ei}$ pour un accumulateur i se calcule par la formule suivante, calculée sur la durée de la phase d'équilibrage : $X_{Ei} = \int IE_i \, dt$, où $I_{Ei}$ est le courant d'équilibrage reçu ou partant de l'accumulateur i (il prendra une valeur positive en cas de réception de charge et négative dans le cas contraire).

Lors de cette phase d'équilibrage, l'accumulateur ayant atteint la tension la plus haute lors de la phase de charge est celui qui va le plus se décharger lors de la phase d'équilibrage. En notant $X_{Emin}$ sa charge d'équilibrage, il atteint en fin de la phase d'équilibrage l'état de charge $SOC_E$ défini par la formule :

$$SOC_E = \frac{(X + X_{Emin}) \times 100}{X} \quad (1)$$

En fin d'équilibrage, tous les accumulateurs atteignent la même tension et nous admettrons comme hypothèse qu'ils ont tous atteint le même état de charge. Pour l'accumulateur i, sa capacité maximale $C_{maxi}$ à l'instant donné, en fin de phase d'équilibrage, se définit donc par la formule suivante :

$$C_{maxi} = \frac{(X + X_{Ei}) \times 100}{SOC_E} \quad (2)$$

L'état de santé $SOH_i$ d'un accumulateur particulier i est calculé comme le rapport entre sa capacité maximale $C_{maxi}$ à un instant donné et sa capacité maximale Ci en début de vie, soit par la formule :

$$SOH_i = C_{maxi} / Ci * 100 \quad (3)$$

En intégrant les équations (1) et (2) dans cette équation (3), l'état de santé $SOH_i$ est finalement obtenu, dans une troisième étape du procédé, par le calcul suivant :

$$SOH_i = \frac{(X + X_{Ei}) \times 100}{C_i (X + X_{Emin})/X}$$

Le procédé comprend avantageusement une étape préliminaire de charge ou décharge totale puis d'équilibrage de tous les accumulateurs, pour définir un état initial bien connu servant de référence.

En remarque, la mise en oeuvre du procédé précédent est réalisée, selon un mode de réalisation, par la mesure des courants circulant dans tout ou partie des accumulateurs de la batterie lors d'au moins la phase d'équilibrage de la batterie. Pour cela, la batterie peut se présenter sous la forme illustrée par la figure 4, dans laquelle un capteur de courant 15 est disposé en série avec chaque accumulateur $A_i$.

En variante, cette mesure de courant peut être estimée par tout modèle ou toute autre méthode.

Le procédé mis en oeuvre et décrit ci-dessus présente l'avantage de permettre un calcul simple et fiable de l'état de santé de tout ou partie des accumulateurs d'une batterie, simultanément à une phase de charge et d'équilibrage, sans nécessiter une immobilisation supplémentaire de la batterie, spécifique à son diagnostic.

Le mode de réalisation précédent a été décrit en choisissant d'observer les charges impliquées pour en déduire une grandeur représentant l'état de santé SOH d'un accumulateur, comme défini précédemment. En remarque, cet état de santé pourrait aussi s'évaluer par l'observation d'autres grandeurs électriques, par exemple comme les puissances offertes par un accumulateur, et donc l'énergie stockée et restituée, qui évolue en diminuant avec le vieillissement de la batterie. L'implémentation de cette approche peut être réalisée sur la base d'une batterie telle que représentée sur la figure 4, et sur la base des mesures de tension et de courant.

Ainsi, le procédé de l'invention décrit précédemment peut être mis en oeuvre plus généralement en observant deux grandeurs électriques $G_{min}$ et $G_i$ représentant respectivement l'équilibrage de l'accumulateur ayant atteint la tension maximale lors de phase de charge et la même grandeur électrique $G_i$ représentant l'équilibrage d'un accumulateur particulier i distinct. La batterie peut alors comprendre tout capteur de mesure nécessaire à la connaissance de la grandeur électrique G choisie.

Le procédé a été décrit lors d'une charge d'une batterie, durant laquelle la grandeur Gmin représente l'équilibrage de l'accumulateur ayant atteint la tension maximale. Ce procédé peut aisément être transposé à une décharge d'une batterie, durant laquelle la grandeur Gmin représente l'équilibrage de l'accumulateur ayant atteint la tension minimale lors de la décharge.

L'invention porte aussi sur une batterie en tant que telle, se présentant comme illustré en figure 4, et comprenant en outre un circuit de commande de ses interrupteurs, ainsi qu'au moins un calculateur pour mettre en oeuvre les calculs explicités. Ces composants peuvent être internes à la batterie. En variante, tout ou partie des étapes du procédé peut être réalisée dans une unité externe d'un système de diagnostic de batterie.

## Revendications

1. Procédé de gestion d'une batterie (10) comprenant plusieurs accumulateurs $A_i$ pouvant être liés en série ou en parallèle, comprenant une phase de charge ou de décharge durant laquelle les accumulateurs sont disposés en série, comprenant ensuite une phase d'équilibrage comprenant la mise en parallèle des accumulateurs, **caractérisé en ce que** durant laquelle une grandeur électrique $G_{min}$ représentant l'équilibrage de l'accumulateur ayant atteint la tension maximale lors de la phase de charge ou minimale lors de la phase de décharge est mesurée ou estimée, et durant laquelle une grandeur électrique $G_i$ représentant l'équilibrage d'un autre accumulateur i dé la batterie est aussi mesurée ou estimée, et **en ce que** l'état de santé $SOH_i$ de cet autre accumulateur i est calculé à partir des deux grandeurs électriques $G_{min}$ et $G_i$ et à partir de la connaissance de la performance de l'accumulateur i en début de vie.

**2.** Procédé de gestion d'une batterie selon la revendication précédente, **caractérisé en ce qu'**il comprend une étape préliminaire de décharge totale ou de charge totale et d'équilibrage de tous les accumulateurs.

**3.** Procédé de gestion d'une batterie selon la revendication 1 ou 2, **caractérisé en ce que** l'état de santé $SOH_i$ de l'accumulateur i est calculé comme le rapport entre sa capacité maximale en fin de phase d'équilibrage de la batterie et sa capacité maximale en début de vie et **en ce que** les deux grandeurs $G_{min}$ et $G_i$ sont des capacités en A.h.

**4.** Procédé de gestion d'une batterie selon la revendication précédente, **caractérisé en ce qu'**il comprend les étapes suivantes :

- mesure ou estimation de la capacité chargée X pendant la phase de charge ou de la capacité déchargée pendant la phase de décharge ;
- mesure ou estimation de la charge d'équilibrage $X_{Emin}$ de l'accumulateur ayant atteint la tension maximale à la fin de la phase de charge ou la tension minimale à la fin de la phase de décharge ;
- mesure ou estimation de la charge d'équilibrage $X_{Ei}$ de l'accumulateur i ;
- calcule de l'état de santé $SOH_i$ de l'accumulateur i par la formule suivante :

$$SOH_i = \frac{(X+X_{Ei}) \times 100}{C_i (X+X_{Emin})/X}$$

Où $C_i$ représente la capacité maximale en début de vie de l'accumulateur i.

**5.** Procédé de gestion d'une batterie selon la revendication précédente, **caractérisé en ce qu'**il comprend les étapes suivantes :

- mesure du courant I de charge ou de décharge traversant tous les accumulateurs disposés en série et calcul de la capacité chargée X pendant la phase de charge ou de la capacité déchargée pendant la phase de décharge par la formule $X = \int I \, dt$ sur la durée de la phase de charge ou de décharge ;
- mesure du courant $I_{Emin}$ d'équilibrage au niveau de l'accumulateur ayant atteint la tension maximale en fin de phase de charge ou la tension minimale en fin de phase de décharge et calcul de la charge d'équilibrage $X_{Emin}$ pendant la phase d'équilibrage par la formule $X_{Emin} = \int I_{Emin} \, dt$ sur la durée de la phase d'équilibrage ;
- mesure du courant $I_{Ei}$ d'équilibrage au niveau de l'accumulateur i et calcul de la charge d'équilibrage $X_{Ei}$ pendant la phase d'équilibrage par la formule $X_{Ei} = \int I_{Ei} \, dt$ sur la durée de la phase d'équilibrage.

**6.** Procédé de gestion d'une batterie selon la revendication 1, **caractérisé en ce que** l'état de santé $SOH_i$ de l'accumulateur i est calculé comme le rapport entre l'énergie maximale stockée en fin de phase d'équilibrage de la batterie et son énergie maximale stockée en début de vie et **en ce que** les deux grandeurs $G_{min}$ et $G_i$ sont des énergies.

**7.** Procédé de gestion d'une batterie selon l'une des revendications précédentes, **caractérisé en ce qu'**il comprend une étape de calcul de l'état de santé SOH de tous les accumulateurs de la batterie pendant les phases de recharge et d'équilibrage de la batterie ou de décharge et d'équilibrage dé la batterie.

**8.** Batterie (10) comprenant plusieurs accumulateurs $(A_i)$ pouvant être connectés en série ou en parallèle, **caractérisée en ce qu'**elle comprend un calculateur qui met en oeuvre le procédé de gestion selon l'une des revendications précédentes.

**9.** Batterie selon la revendication précédente, **caractérisée en ce qu'**elle comprend des interrupteurs (12, 14) entre différents accumulateurs $(A_i)$ pour les disposer en série ou en parallèle, au moins un capteur de mesure (15), un circuit de commande des interrupteurs et un calculateur qui reçoit les mesures et effectue le calcul de l'état de santé d'au moins un accumulateur.

**10.** Système de gestion d'une batterie, **caractérisé en ce qu'**il comprend au moins un calculateur qui met en oeuvre le procédé de gestion d'une batterie selon l'une des revendications 1 à 7.

**Patentansprüche**

**1.** Verfahren zur Verwaltung einer Batterie (10), die mehrere Akkumulatoren $(A_i)$ enthält, welche in Reihe oder parallel geschaltet sein können, das eine Lade- oder Entladephase enthält, während der die Akkumulatoren in Reihe geschaltet sind, dann eine die Parallelschaltung der Akkumulatoren enthaltende Ausgleichsphase enthält, **dadurch gekennzeichnet, dass** während dieser eine elektrische Größe $G_{min}$, die den Ausgleich des Akkumulators darstellt, der während der Ladephase eine maximale Spannung oder während der Entladephase eine minimale Spannung erreicht hat, gemessen oder geschätzt wird, und während dieser eine elektrische Größe $G_i$, die den Ausgleich eines anderen Akkumulators i der Batterie darstellt, auch gemessen oder geschätzt wird, und dass der Gesundheitszustand $SOH_i$ dieses

anderen Akkumulators i ausgehend von den zwei elektrischen Größen $G_{min}$ und $G_i$ und ausgehend von der Kenntnis der Leistung des Akkumulators i am Beginn der Lebensdauer berechnet wird.

2.  Verfahren zur Verwaltung einer Batterie nach dem vorhergehenden Anspruch, **dadurch gekennzeichnet, dass** es einen vorhergehenden Schritt der Gesamtentladung oder der Gesamtladung und des Ausgleichs aller Akkumulatoren enthält.

3.  Verfahren zur Verwaltung einer Batterie nach Anspruch 1 oder 2, **dadurch gekennzeichnet, dass** der Gesundheitszustand $SOH_i$ des Akkumulators i als das Verhältnis zwischen seiner maximalen Kapazität am Ende der Ausgleichsphase der Batterie und seiner maximalen Kapazität am Beginn der Lebensdauer berechnet wird, und dass die zwei Größen $G_{min}$ und $G_i$ Kapazitäten in Ah sind.

4.  Verfahren zur Verwaltung einer Batterie nach dem vorhergehenden Anspruch, **dadurch gekennzeichnet, dass** es die folgenden Schritte enthält:

    - Messung oder Schätzung der während der Ladephase geladenen Kapazität X oder der während der Entladephase entladenen Kapazität;
    - Messung oder Schätzung der Ausgleichsladung $X_{Emin}$ des Akkumulators, der am Ende der Ladephase die maximale Spannung oder am Ende der Entladephase die minimale Spannung erreicht hat;
    - Messung oder Schätzung der Ausgleichsladung $X_{Ei}$ des Akkumulators i;
    - Berechnung des Gesundheitszustands $SOH_i$ des Akkumulators i durch die folgende Formel:

    $$SOH_{i=}\frac{(X + X_{Ei})x100}{C_i(X + X_{Emin})/X}$$

    wobei $C_i$ die maximale Kapazität am Beginn der Lebensdauer des Akkumulators i darstellt.

5.  Verfahren zur Verwaltung einer Batterie nach dem vorhergehenden Anspruch, **dadurch gekennzeichnet, dass** es die folgenden Schritte enthält:

    - Messung des Lade- oder Entladestroms I, der alle in Reihe geschalteten Akkumulatoren durchquert, und Berechnung der während der Ladephase geladenen Kapazität X oder der während der Entladephase entladenen Kapazität durch die Formel $X = \int I \, dt$ über die Dauer der Lade- oder Entladephase;
    - Messung des Ausgleichsstroms $I_{Emin}$ im Bereich des Akkumulators, der am Ende der Ladephase die maximale Spannung erreicht hat oder am Ende der Entladephase die minimale Spannung erreicht hat, und Berechnung der Ausgleichsladung $X_{Emin}$ während der Ausgleichsphase durch die Formel $X_{Emin} = \int I_{Emin} \, dt$ über die Dauer der Ausgleichsphase;
    - Messung des Ausgleichstroms $I_{Ei}$ im Bereich des Akkumulators i und Berechnung der Ausgleichsladung $X_{Ei}$ während der Ausgleichsphase durch die Formel $X_{Ei} = \int I_{Ei} \, dt$ über die Dauer der Ausgleichsphase.

6.  Verfahren zur Verwaltung einer Batterie nach Anspruch 1, **dadurch gekennzeichnet, dass** der Gesundheitszustand $SOH_i$ des Akkumulators i als das Verhältnis zwischen der am Ende der Ausgleichsphase der Batterie gespeicherten maximalen Energie und ihrer am Beginn der Lebensdauer gespeicherten maximalen Energie berechnet wird, und dass die zwei Größen $G_{min}$ und $G_i$ Energien sind.

7.  Verfahren zur Verwaltung einer Batterie nach einem der vorhergehenden Ansprüche, **dadurch gekennzeichnet, dass** es einen Schritt der Berechnung des Gesundheitszustands SOH aller Akkumulatoren der Batterie während der Auflade- und Ausgleichsphasen der Batterie oder der Entlade- und Ausgleichsphasen der Batterie enthält.

8.  Batterie (10), die mehrere Akkumulatoren ($A_i$) enthält, die in Reihe oder parallel geschaltet sein können, **dadurch gekennzeichnet, dass** sie einen Rechner enthält, der das Verwaltungsverfahren nach einem der vorhergehenden Ansprüche anwendet.

9.  Batterie nach dem vorhergehenden Anspruch, **dadurch gekennzeichnet, dass** sie Unterbrecher (12, 14) zwischen verschiedenen Akkumulatoren ($A_i$), um sie in Reihe oder parallel anzuordnen, mindestens einen Messwertsensor (15), einen Steuerschaltkreis der Unterbrecher und einen Rechner enthält, der die Messwerte empfängt und die Berechnung des Gesundheitszustands mindestens eines Akkumulators ausführt.

10. System zur Verwaltung einer Batterie, **dadurch gekennzeichnet, dass** es mindestens einen Rechner enthält, der das Verfahren zur Verwaltung einer Batterie nach einem der Ansprüche 1 bis 7 anwendet.

**Claims**

1.  Method for managing a battery (10) comprising several accumulators ($A_i$) that can be linked in series or in parallel, comprising a charging or discharging phase during which the accumulators are disposed in series, thereafter comprising a balancing phase comprising the placing of the accumulators in parallel, **characterized in that** it during which an electrical quantity $G_{min}$ representing the balancing of the accumulator that has attained the maximum voltage during the charging phase or minimum voltage during the discharging phase is measured or estimated, and during which an electrical quantity $G_i$ representing the balancing of another accumulator i of the battery is also measured or estimated, and **in that** the state of health $SOH_i$ of this other accumulator i is computed on the basis of the two electrical quantities $G_{min}$ and $G_i$ and on the basis of the knowledge of the performance of the accumulator i at the start of life.

2. Method for managing a battery according to the preceding claim, **characterized in that** it comprises a preliminary step of total discharging or total charging and balancing of all the accumulators.

3. Method for managing a battery according to Claim 1 or 2, **characterized in that** the state of health $SOH_i$ of the accumulator i is computed as the ratio of its maximum capacity at the end of the battery balancing phase to its maximum capacity at the start of life and **in that** the two quantities $G_{min}$ and $G_i$ are capacities in A.h.

4. Method for managing a battery according to the preceding claim, **characterized in that** it comprises the following steps:

   - measurement or estimation of the capacity charged X during the charging phase or of the capacity discharged during the discharging phase;
   - measurement or estimation of the balancing charge $X_{Emin}$ of the accumulator that has attained the maximum voltage at the end of the charging phase or the minimum voltage at the end of the discharging phase;
   - measurement or estimation of the balancing charge $X_{Ei}$ of the accumulator i;
   - computation of the state of health $SOH_i$ of the accumulator i via the following formula:

$$SOH_i = \frac{(X + X_{Ei}) \times 100}{C_i (X + X_{Emin})/X}$$

   Where $C_i$ represents the maximum capacity at the start of life of the accumulator i.

5. Method for managing a battery according to the preceding claim, **characterized in that** it comprises the following steps:

   - measurement of the charging or discharging current I passing through all the accumulators disposed in series and computation of the capacity charged X during the charging phase or of the capacity discharged during the discharging phase via the formula $X = \int I \, dt$ over the duration of the charging or discharging phase;
   - measurement of the balancing current $I_{Emin}$ at the level of the accumulator that has attained the maximum voltage at the end of the charging phase or the minimum voltage at the end of the discharging phase and computation of the balancing charge $X_{Emin}$ during the balancing phase via the formula $X_{Emin} = \int I_{Emin} \, dt$ over the duration of the balancing phase;
   - measurement of the balancing current $I_{Ei}$ at the level of the accumulator i and computation of the balancing charge $X_{Ei}$ during the balancing phase via the formula $X_{Ei} = \int I_{Ei} \, dt$ over the duration of the balancing phase.

6. Method for managing a battery according to Claim 1, **characterized in that** the state of health $SOH_i$ of the accumulator i is computed as the ratio of the maximum energy stored at the end of the battery balancing phase to its maximum energy stored at the start of life and **in that** the two quantities $G_{min}$ and $G_i$ are energies.

7. Method for managing a battery according to one of the preceding claims, **characterized in that** it comprises a step of computing the state of health SOH of all the accumulators of the battery during the battery recharging and balancing or battery discharging and balancing phases.

8. Battery (10) comprising several accumulators ($A_i$) that can be connected in series or in parallel, **characterized in that** it comprises a computer which implements the management method according to one of the preceding claims.

9. Battery according to the preceding claim, **characterized in that** it comprises switches (12, 14) between different accumulators ($A_i$) so as to dispose them in series or in parallel, at least one measurement sensor (15), a control circuit for the switches and a computer which receives the measurements and performs the computation of the state of health of at least one accumulator.

10. System for managing a battery, **characterized in that** it comprises at least one computer which implements the method for managing a battery according to one of Claims 1 to 7.

## FIG.1

## FIG.2

# FIG.3

# FIG.4

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2008072859 A